# EUROPEAN PATENT SPECIFICATION

(11) **EP 2 228 830 B1**
(45) Date of publication and mention of the grant of the patent: **26.09.2018**
(21) Application number: 10155444.2
(22) Date of filing: 04.03.2010
(51) Int. Cl.: H02S 40/34

(54) **Connecting device for connecting to a solar module, and solar module with a connection device of this type**
Anschlussvorrichtung zum Anschließen eines Solarmoduls und Solarmodul mit Anschlussvorrichtung dieser Art
Dispositif de connexion pour la connexion à un module solaire et module solaire doté d'un dispositif de connexion de ce type

(30) Priority: 10.03.2009 DE 102009012539
(43) Date of publication of application: 15.09.2010
(73) Proprietor: TE Connectivity Germany GmbH, 64625 Bensheim (DE)
(72) Inventor: Scherer, Heinz Peter, 64625 Bensheim (DE); Feldmeier, Günter, 64653 Lorsch (DE); Novak, Istvàn, 70619 Stuttgart (DE)
(74) Representative: Schmitt-Nilson Schraud Waibel Wohlfrom Patentanwälte Partnerschaft mbB

(56) References cited:
- WO-A1-2009/021647
- DE-A1-102006 056 259
- DE-A1-102007 006 433

## Description

The present invention relates to a connecting device for connecting to an electrical connection system of a solar module with a connector housing to be arranged on an outer surface of the solar module and with at least one current-carrying component which is arranged in the connector housing and can be connected to an electrical conductor, which is led out of the solar module, of the electrical connection system of the solar module via a connection means.

In a typical embodiment, a photovoltaic solar module comprises a panel-like layered arrangement with solar cells which are arranged between two outer layers and generate electrical energy by a photovoltaic effect. The solar cells are generally arranged between the outer layers in a corresponding intermediate space and are interconnected to one another within the layered arrangement with an electrical connection system. Embodiments of solar modules are in this regard known in which the electrical connection system of the solar cells is outwardly connected, e.g. to a consumer, at the back, which is remote from the irradiation side, of the solar module by means of electrical conductors, for example in the form of connection foils. These connection foils are connected in one or more connecting devices, which are designed for example in the form of a connection case or a connection outlet, to one or more electrical conductors of a connection line. For this purpose, a connecting device of this type has one or more current-carrying components which are arranged in a connector housing and to which, on the one hand, one or more connection foils of the solar module and, on the other hand, one or more electrical conductors of one or more connection cables are connected. In addition, a connecting device of this type can contain one or more diodes which are provided to prevent compensating currents between solar cells located in sunlight and solar cells located in the shade, which solar cells supply different solar currents and solar voltages. With the aid of what are known as bypass diodes of this type, the module can continue to be operated even with partial shading and corresponding reduced power.

The current-carrying component or components arranged in the connector housing are connected to an electrical conductor, which is led out of the solar module, generally via a connection means. For example, provision is made for the led-out contact track ends to be placed against or around connection contacts of the current-carrying components that are arranged perpendicularly to the solar module, so that the connection contacts contact the led-out contact track ends on both sides. Spring elements, which are each slid over a corresponding connection contact and press the respective contact track against the connection contact on both sides, are for example used for fixing the contact track ends.

A drawback of the described connection outlet arrangement consists in the fact that the spring elements have to be slid over the contact track ends or connection foils, wherein the contact track ends can in the process become displaced until the respective spring element has reached its final position. This results substantially from the fact that the respective spring element for establishing the contacting is moved along the contact track while exerting contacting pressure, as a result of which said contact track can become displaced. Furthermore, a drawback consists in the fact that assembly is relatively complex, as the contact track ends must firstly be placed around a corresponding connection contact and be held in this position so that the spring element can be slid over a contact track end.

DE 10 2006 056259 A1 discloses a printed circuit board assembly which includes a PCB and a screwless terminal connection having a conductor rail and a clamping spring. The clamping spring includes multiple spring legs, wherein a first leg contacts a base part of the conductor rail soldered to the PCB, a second leg extends from the first leg through a PCB recess and is beneath the PCB and a third leg includes a clamping aperture and extends upward from the second leg above the PCB. A terminal end of a conductor to be connected to the terminal connection is introduced through the clamping aperture. The conductor is then retained to the terminal connection by being clamped in by an upper edge of the clamping aperture. A second aperture serves as an actuation aperture through which a tool is introduced to open the terminal connection and to release the conductor from being clamped by the upper edge of the clamping aperture.

The present invention is based on the object of disclosing a connecting device of the type mentioned at the outset allowing comparatively simple contacting of the connecting device with a connection system of a solar module with at the same time high contact security.

This object is achieved by a connecting device according to the features of claim 1. Furthermore, the invention relates to a solar installation according to the features of claim 10.

The invention offers in this regard the advantage that the connector housing can be attached to the solar module in a largely automated manner and can be connected to led-out conductors of the connection system of the solar module. In particular, it is not necessary to firstly place the contact track ends or connection foils led out of the solar module against or around connection contacts provided for this purpose of the current-carrying components, so that the connection contacts contact the led-out contact track ends before said contact track ends are fixed to the corresponding connection contact using a spring element. Instead, according to the invention, the connection means is embodied in such a way that the current-carrying component can be connected in one operation to a conductor which is led out of the solar module. This is achieved in particular in that the connection means is preferably moulded onto the current-carrying component and can be moved out of its contacting position with the aid of a tool by engaging with the engagement portion of the resiliently embodied contact region when the current-carrying component is connected to the led-out conductor. On the one hand, this eliminates the need for a separate spring element. On the other hand, the engagement portion allows the connection means for establishing the contacting to be moved along the contact track of the led-out conductor not while exerting contacting pressure, for example in that a tool moves the resiliently embodied contact region out of its contacting position during the attachment of the connector housing to the solar module. In this way, the resiliently embodied contact region can be led contactlessly past the led-out conductor before it contacts the conductor in the contacting position while exerting contacting pressure. According to the invention, a displacement of the led-out conductor of the solar module is thus effectively prevented during the course of the contacting with the connecting device. In this way, it is no longer necessary to stabilise the led-out conductor in a separate operating step by abutting it against an abutment surface.

The concept according to the invention has proven particularly advantageous if the led-out conductor is designed as a connection foil, for example in the form of a flat strip, having comparatively low rigidity. The lower inherent rigidity presents the risk of the connection foil being displaced comparatively easily during contacting with a contact of the connecting device. This risk is counteracted with the aid of the concept according to the invention in that the engagement portion allows the resiliently embodied contact region to be moved out of its contacting position, advantageously in the same operation during the attachment of the connector housing to the solar module.

The engagement portion provided can in principle be any type of device which is suitable for interacting with a corresponding tool in order to move the resiliently embodied contact region out of its contacting position.

In one embodiment of the invention, the connection means has a mating contact region opposing the resiliently embodied contact region, the resiliently embodied contact region being embodied to press, in the contacting position, the led-out conductor against the opposing mating contact region of the connection means. This allows effective contacting of the led-out conductor on both sides to be ensured without this requiring the use of a separate connection contact surface around which the led-out conductor is firstly placed.

For example, the engagement portion is embodied in the form of a gap or slot, so that the resiliently embodied contact region is moved away from the opposing mating contact region of the connection means merely by engaging a tool. In other words, the connection means can be opened by engaging the tool in that the resiliently embodied contact region is moved away from the opposing region of the connection means, so that the led-out conductor can be inserted therebetween. In this example, the opening is accordingly carried out based on the thickness of the tool. No further pivoting movement or the like of the tool is therefore required.

According to a further preferred embodiment, the engagement portion is provided adjacent to the connecting region. In this embodiment, the width of the connecting region is less than the width of the contact and mating contact regions such that there is formed at both sides of the connecting region a gap which can be accessed from above and with which a corresponding tool can engage. Accordingly, the tool engages between the resiliently embodied contact region and the opposing mating contact region of the connection means in order to move said contact regions apart. In this exemplary embodiment, merely the thickness of the tool causes the movement, i.e. a pivoting movement of the tool is conceivable, but not required.

For example, the connection means is embodied as a curved spring contact with a mating contact region which is moulded onto the current-carrying component and merges with the resiliently embodied contact region via a curved connecting region. For example, the resiliently embodied contact region and the connecting region jointly form in cross section roughly an S shape or Z shape.

In a further embodiment of the invention, at least one bulge or bead is formed at the side of the contact region that faces the mating contact region. This bulge or bead can for example serve to form at least one contact point or a contacting surface with the led-out conductor. As a result, it is possible to provide in particular a plurality of contacting points or surfaces, thus increasing the contacting security. Furthermore, the bulge or bead can serve to better fix the foil.

Preferably, the current-carrying component is embodied as a bus bar in which a connection region is provided on a first side for connecting to at least one electrical conductor and the connection means is provided on a second side opposing the first side. In the connection region on the first side, a connection cable can for example be indirectly or directly connected in order to connect the solar module e.g. to another solar module or to an external consumer.

In order to provide a simple contacting option, the bus bar can be connected at the first side in the connection region to a contact which forms on a side remote from the bus bar a part of a plug-in connection device to which an external conductor can be connected. The bus bar can thus be connected via the contact to a plug connector provided e.g. on a connection cable.

Further advantageous embodiments and developments of the invention are disclosed in the sub-claims.

The invention will be described in greater detail hereinafter with reference to the figures which are illustrated in the drawings and illustrate embodiments in relation to the present invention. In the drawings
- Fig. 1: is a schematic cross-sectional view of an exemplary photovoltaic solar module connected to a connecting device according to the invention;

- Fig. 2: is a cross-sectional view of a connector housing with a current-carrying component arranged therein and a connection means moulded onto the component according to an example;

- Fig. 3: is a plan view and a side view of the connector housing according to Fig. 2;
- Fig. 4-6: are each a perspective illustration of a current-carrying component in the form of a bus bar with a connection means moulded thereon according to an embodiment of the invention for contacting an electrical conductor led out of the solar module as shown in Fig. 1; and
- Fig. 7: is a schematic cross-sectional view of a bus bar which is placed on a solar module and has a moulded-on connection means according to the example as shown in Fig. 2.

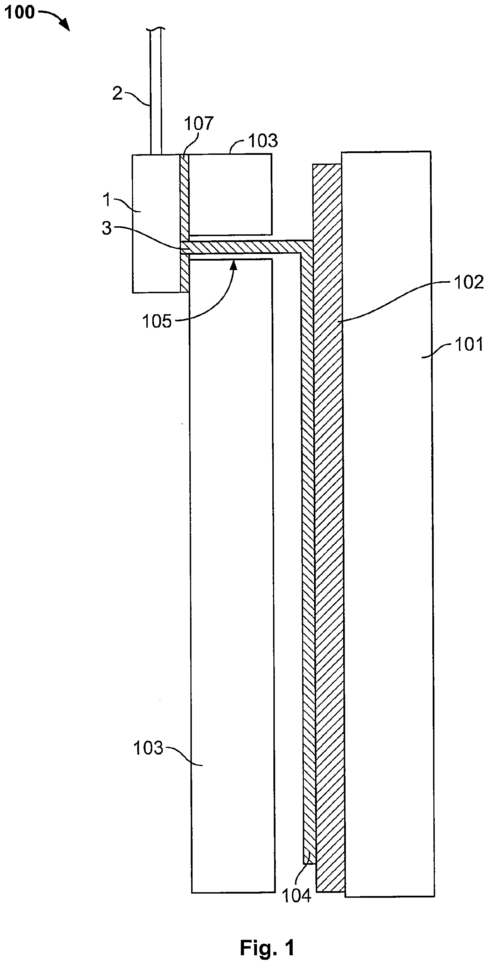

Fig. 1 is a schematic cross-sectional illustration (not true to scale) of a photovoltaic solar module provided with a connecting device in the form of a connection outlet or a connection box. The solar module 100 comprises a layered arrangement with a sheet-like, irradiation-side first layer 101 which can be designed in the form of a glass plate or a foil-like layer. Furthermore, the solar module 100 comprises a sheet-like second layer 103 which is remote from the irradiation side and can also be embodied in the form of a glass plate or a foil-like layer. In the present embodiment, the layers 101 and 103 are designed as respective glass plates. Located between the two layers 101 and 103 is at least one solar cell 102 or an arrangement made up of a plurality of solar cells 102 which, when irradiated with light, supply electrical energy based on a photovoltaic effect. The solar cell(s) 102 is/are connected to an electrical connection system 104. Said electrical connection system is indicated merely schematically in Fig. 1 and serves in particular to electrically interconnect the solar cell(s) and to connect them to the outside world. The electrical connection system 104 comprises for example a copper foil which, on the one hand, is electrically contacted with the back of the solar cell(s) 102 and, on the other hand, merges with one or more electrical conductors 3 of the solar module or is connected to at least one electrical conductor 3 of the solar module which is designed for example in the form of a connection foil or a connection strip and is led out of the solar module. The electrical connection system 104 of the solar module 100 can be connected to an external connection line 2, for example in the form of a solar connection cable, via one or more foil conductors 3 of this type.

As is also illustrated in Fig. 1, a connecting device 1 is fastened to the back of the layer 103, which forms an outer surface of the solar module, as will be described hereinafter in greater detail, for example by adhesive bonding by means of adhesive 107. Furthermore, the layer 103 has a lead-through opening 105 through which the electrical conductor 3, for example in the form of a foil conductor, can be led to the connecting device 1.

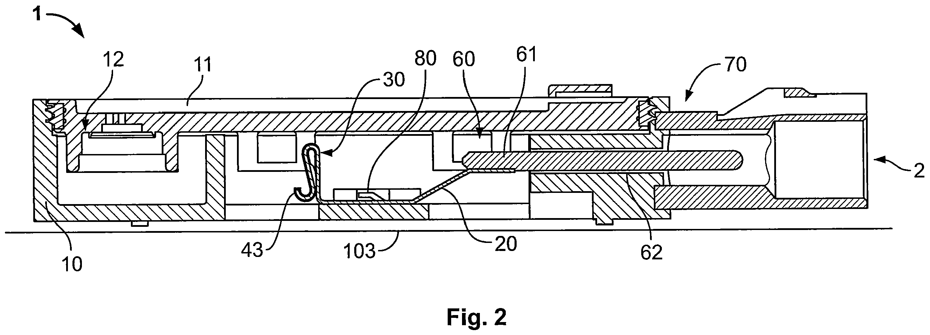

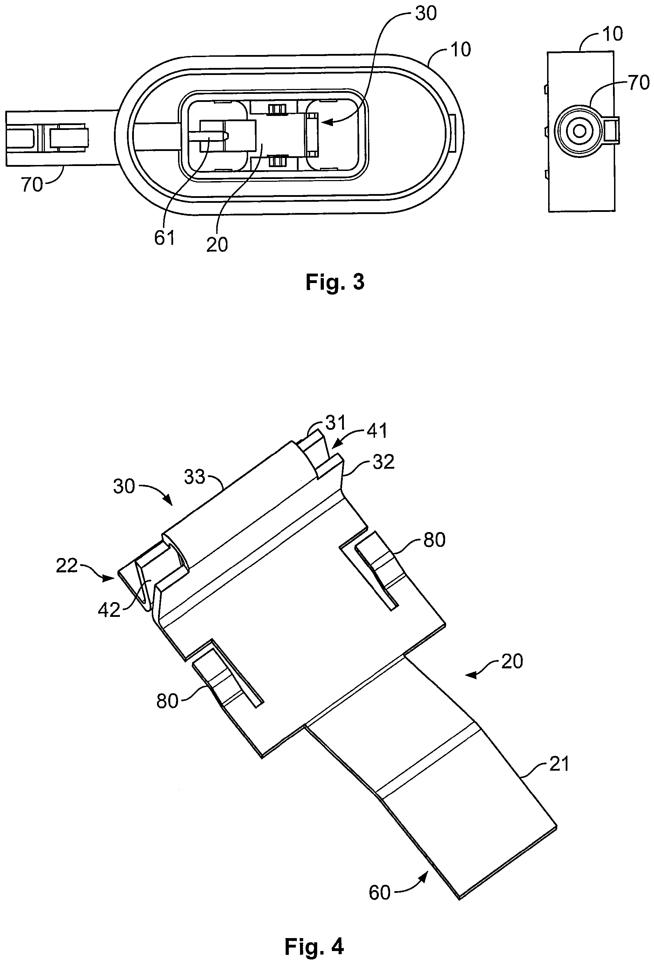

Figures 2 and 3 show an example of a connector housing 10 with components arranged therein, such as can be used for a connecting device 1. For example, the connector housing 10 contains an exemplary current-carrying component 20 which is arranged therein and is designed in the form of a bus bar, as illustrated in greater detail in Fig. 4-6. The composition and mode of operation of the individual components illustrated in Figures 2 to 7 will be described hereinafter in greater detail.

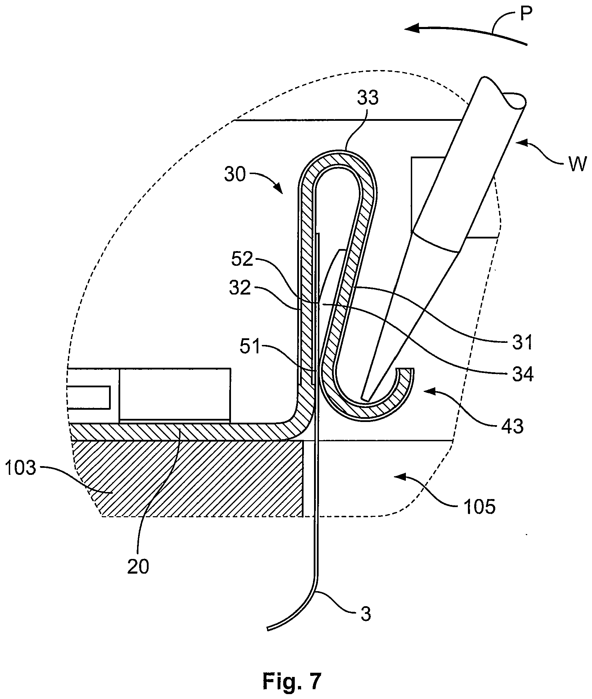

As is illustrated in greater detail in Figures 2 and 7, viewed in conjunction with each other, a led-out conductor 3 is led out of the solar module in a roughly vertical direction through the lead-through opening 105 of the layer 103 in order to be contacted by a connection means 30. The led-out conductor is for example designed as a foil conductor. In the present embodiment, the connection means 30 is embodied as a curved spring contact and has a region 32 which is moulded onto the bus bar 20 and merges with a resiliently embodied contact region 31 via a curved connecting region 33.

The region 32 moulded onto the bus bar 20 forms a mating contact region opposing the resiliently embodied contact region 31. In this case, the resiliently embodied contact region 31 presses, in the contacting position, as illustrated in Fig. 7, the led-out conductor 3 against the mating contact region 32. In the contacting position, contacting is provided in particular at the contact point or the contacting surface 51 at which the leg forming the contact region 31 presses against the opposing mating contact region or leg 32 of the spring contact 30. In this embodiment, the mating contact region 32 is moulded onto the bus bar 20 roughly perpendicularly. Fig. 7 shows in this regard that the resiliently embodied contact region 31 and the connecting region 33 jointly form in cross section roughly an S shape or Z shape. As a result, it is possible for the foil conductor 3 to be inserted into the intermediate space thus formed between the legs of the spring contact 30 and to be contacted. In order to increase the contact security, the resiliently embodied contact region 31 can have one or more bulges or beads 34 in order to form one or more additional contact points 52 or contacting surfaces with the foil conductor 3.

In the connector housing 10 according to Figures 2 and 3, the present example provides only one bus bar 20, the design type and arrangement of which are to be regarded as being merely exemplary and can also vary as required. Furthermore, the number of bus bars used can also vary as required. On a first side 21 of the bus bar, a connection region 60 is provided for connecting to at least one electrical conductor 61. The conductor 61 can for example be designed as a contact, in particular a contact pin, which is welded or otherwise connected to the bus bar 20 in the connection region 60. It goes without saying that the conductor itself can also be welded-on directly. On a second side 22, opposing the first side 21, of the bus bar, the connection means 30 is provided in the form of a curved spring contact, as described in greater detail hereinbefore.

In the connection region 60, the bus bar 20 can be connected to one or more conductors of a connection cable 2 via the contact 61. Said connection cable is not illustrated in greater detail in Fig. 2. The contact 61 forms for this purpose on a side remote from the bus bar 20 a part of a plug-in connection device 70 to which the connection cable 2 can be connected, e.g. via a suitable corresponding plug connector. The contact 61 is secured in the contact lead-through 62 of the connector housing 10 and forms on sides of the plug-in connection device 70 a pin contact which can be connected to a corresponding socket contact on sides of the connection cable 2. In principle, any types of contacting options are conceivable in this connection.

The bus bar 20 is for example interlocked or otherwise fastened to a corresponding locking element in the connector housing 10. For this purpose, the bus bar 20 has in a region located between the first side 21 and second side 22 at least one fastening portion 80 which is provided to fix the bus bar 20 in the connector housing 10. The fastening portion 80 has e.g. one or more interlocking arms (as may be seen from Figures 4-6) which engage with a corresponding mating interlocking means attached to the housing bottom of the connector housing, as indicated in Fig. 2. The connector housing 10 is closed by a housing cover 11 and can be aerated or de-aerated via an aeration means 12.

In addition to the aforementioned connection regions for contacting a led-out conductor 3, on the one hand, and a connection cable 2, on the other hand, the bus bar 20 can also have a contact region which is provided for contacting a diode component, in particular in an embodiment in which a plurality of bus bars are arranged in the connector housing 10. A diode component of this type can in particular perform the function of what is known as a bypass diode.

Figures 2 and 7 show the connection means 30 according to the example the contact region 31 being shown in its contacting position. In this first embodiment, the free end of the contact region 31 is embodied as a channel-like bend 43. This channel-like bend 43 forms the engagement portion 43. For contacting the conductor 3, a tool W is inserted into the engagement portion 43 and subsequently moved in the direction of the arrow P. As a result, the contact region 31 is moved out of the contacting position, thus creating a gap between the contact region 31 and the mating contact region 32. The conductor 3 is inserted into the gap and the tool W is afterwards led out of the engagement portion 43, as a result of which the contact region 31 presses the conductor 3 toward the mating contact region 32.

Alternatively, the engagement portion can be embodied, instead of at the free end of the contact region 31, adjacent to the connecting region 33. This embodiment will be described hereinafter in greater detail with reference to Figures 4 to 6.

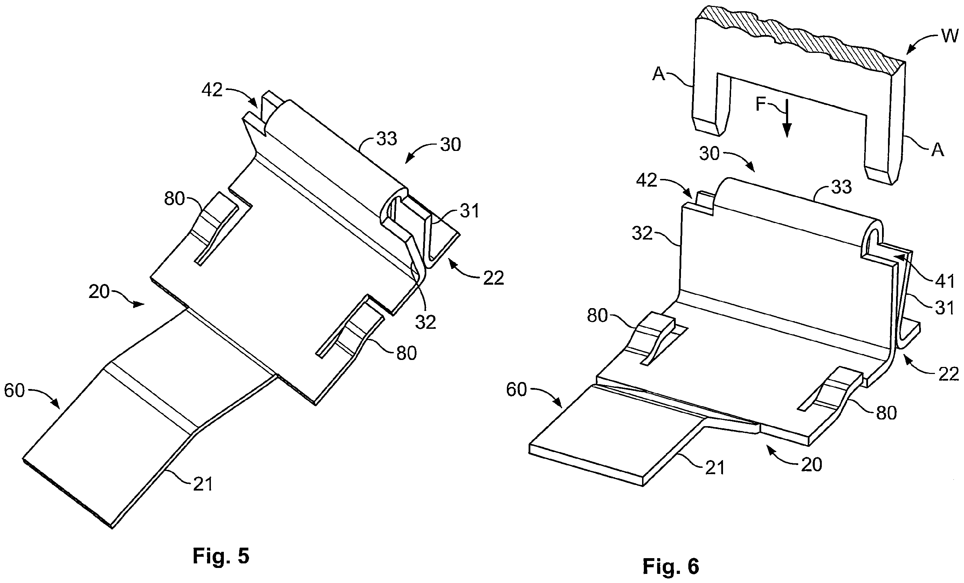

Figure 4 shows that the width of the connecting region 33 is less than the respective width of the contact region 31 and mating contact region 32. As the transverse axis of the connecting region 33 is fixed in such a way that said transverse axis is aligned with the longitudinal axes of the contact region 31 and that of the mating contact region 32, a gap 41, 42, which can be accessed from above, is formed on both sides of the connecting region 33. The gap 41 and the gap 42 thus jointly form the engagement portion according to this alternative embodiment. As shown in Figure 6, the arms A of a tool W are inserted into the respective gap 41, 42 as a result of movement of the tool in the direction F. The resiliently embodied contact portion 31 is moved out of its contacting position as a result of the insertion of the arms A. In particular, this movement out of the contacting position is achieved merely as a result of the insertion of the tool in the direction F, i.e. a subsequent pivoting movement of the tool, as in the first embodiment, is not required here. The thicknesses of the arms A determine how far the contact region 31 is moved away from the mating contact region 32.

In both embodiments of the engagement portion, the foil conductor 3 is thus inserted in a contactless manner. The positioning movement and the insertion and withdrawal of the tool can for example be carried out in a fully automatic manner and in one operation with the aid of the same mounting device.

Thus, in the positioning movement of the connector housing 10, the spring contact 30 can in this case be moved along contactlessly, partly on the led-out conductor 3. After the positioning and adhesive bonding of the housing bottom to the solar module and the closing with the housing cover 11, the components provided in the connector housing 10 are protected from environmental influences. At the same time, secure contacting of the spring contact 30 on the led-out conductor 3 is ensured.

The electrical connection region in the region of the spring contact 30 is easily accessible. In particular, led-out connection foils can be contacted very easily, as the housing-side connection region is very readily accessible. Afterwards, in a positioning movement, the connector housing 10 can be positioned so as to produce a tight seal and the contacting can be established in the process. As a result of the pre-opening of the spring contact 30 during positioning of the connector housing, the corresponding connection foil is not loaded and displaced by spring contact forces and does not have to be supported with the aid of separate abutment surfaces either.

### List of reference numerals

- 1: connecting device
- 2: connection cable
- 3: led-out conductor
- 10: connector housing
- 11: housing cover
- 12: aeration means
- 20: bus bar
- 21: first side
- 22: second side
- 30: connection means
- 31: contact region
- 32: mating contact region
- 33: connecting region
- 34: bulge
- 41, 42, 43: engagement portion
- 51, 52: contact point
- 60: connection region
- 61: contact
- 62: contact lead-through
- 70: plug-in connection device
- 80: fastening device
- 100: solar module
- 101: first layer
- 102: solar cell
- 103: second layer
- 104: electrical connection system
- 105: lead-through opening
- 107: adhesive layer
- F, P: direction arrow
- W: tool
- A: tool arms

## Claims

1. Connecting device (1) for connecting to an electrical connection system (3, 104) of a solar module (100), comprising:
- a connector housing (10) to be arranged on an outer surface (103) of the solar module,
- at least one connection means (30) which can be arranged in the connector housing (10) and can be connected to a conductor (3), which is led out of the solar module, of the electrical connection system of the solar module,
- wherein the connection means (30) has at least one resiliently embodied contact region (31), which is embodied for contacting the led-out conductor (3) in a contacting position, and a mating contact region (32) opposing the resiliently embodied contact region (31), and the resiliently embodied contact region (31) is embodied to press, in the contacting position, the led-out conductor (3) against the mating contact region (32), wherein the contact region (31) and the mating contact region (32) are connected to each other by a connecting region (33),
**characterized by**
- the connection means (30) having at least one engagement portion (41, 42) which is embodied as a gap which is shaped by the contact region (31) and the mating contact region (32) and into which a tool (44) can be inserted in order to move the resiliently embodied contact region (31) out of its contacting position.

2. Connecting device according to claim 1, **characterised in that** the engagement portion (41, 42) is embodied in such a way that the contact region (31) can be moved away from the mating contact region (32) of the connection means by engaging a tool.

3. Connecting device according to claim 1 or 2, **characterised in that** the connecting region (33) is a curved connecting region (33), so that the connection means (30) is embodied as a curved spring contact.

4. Connecting device according to one of claims 1 to 3, **characterised in that** the engagement portion (41, 42) is provided adjacent to the connecting region (33).

5. Connecting device according to one of claims 1 to 4, **characterised in that** the resiliently embodied contact region (31) has at least one bulge or bead (34) for forming a contact point (52) or a contacting surface with the led-out conductor (3).

6. Connecting device according to one of the preceding claims, **characterised in that** the connection means (30) can be moulded onto at least one current-carrying component (20) which can be arranged in the connector housing (10).

7. Connecting device according to claim 6, **characterised in that** the current-carrying component (20) is embodied as a bus bar in which a connection region (60) is provided on a first side (21) for connecting to at least one electrical conductor (61) and the connection means (30) is provided on a second side (22) opposing the first side.

8. Connecting device according to claim 7, **characterised in that** the bus bar is connected at the first side (21) in the connection region (60) to a contact (61) which forms on a side remote from the bus bar (20) a part of a plug-in connection device (70) to which an external conductor (2) can be connected.

9. Connecting device according to claim 7 or 8, **characterised in that** at least one fastening portion (80) of the bus bar (20), which is provided to fix the bus bar (20) in the connector housing (10), is provided between the connection region (60) and the connection means (30).

10. Solar installation comprising at least one solar module (100) and at least one connecting device (1) according to one of the preceding claims.

## Patentansprüche

1. Verbindungsvorrichtung (1) zum Anschluss an ein elektrisches Anschlusssystem (3, 104) eines Solarmoduls (100), aufweisend:
- ein Verbindergehäuse (10) zur Anordnung an einer Außenfläche (103) des Solarmoduls,
- wenigstens eine in dem Verbindergehäuse (10) anordenbare Anschlusseinrichtung (30), die mit einem aus dem Solarmodul herausgeführten Leiter (3) des elektrischen Anschlusssystems des Solarmoduls verbindbar ist,
- wobei die Anschlusseinrichtung (30) wenigstens einen federnd ausgebildeten Kontaktbereich (31) aufweist, der zur Kontaktierung des herausgeführten Leiters (3) in einer Kontaktierungsstellung ausgebildet ist, sowie einen zum federnd ausgebildeten Kontaktbereich (31) gegenüberliegenden Gegenkontaktbereich (32) aufweist und der federnd ausgebildete Kontaktbereich (31) dazu ausgebildet ist, in der Kontaktierungsstellung den herausgeführten Leiter (3) an den Gegenkontaktbereich (32) anzudrücken, wobei der Kontaktbereich (31) und der Gegenkontaktbereich (32) durch einen Verbindungsbereich (33) miteinander verbunden sind,
**dadurch gekennzeichnet,**
- **dass** die Anschlusseinrichtung (30) wenigstens einen Eingriffsabschnitt (41, 42) aufweist, der als ein durch den Kontaktbereich (31) und den Gegenkontaktbereich (32) geformter Spalt ausgebildet ist, in welchen ein Werkzeug (44) einführbar ist, um den federnd ausgebildeten Kontaktbereich (31) aus seiner Kontaktierungsstellung zu bewegen.

2. Verbindungsvorrichtung nach Anspruch 1,
**dadurch gekennzeichnet, dass** der Eingriffsabschnitt (41, 42) derart ausgebildet ist, dass durch den Eingriff eines Werkzeugs der Kontaktbereich (31) von dem Gegenkontaktbereich (32) der Anschlusseinrichtung weg bewegbar ist.

3. Verbindungsvorrichtung nach Anspruch 1 oder 2,
**dadurch gekennzeichnet, dass** der Verbindungsbereich (33) ein gebogener Verbindungsbereich (33) ist, so dass die Anschlusseinrichtung (30) als eine gebogene Kontaktfeder ausgebildet ist.

4. Verbindungsvorrichtung nach einem der Ansprüche 1 bis 3,
**dadurch gekennzeichnet, dass** der Eingriffsabschnitt (41, 42) benachbart zu dem Verbindungsbereich (33) vorgesehen ist.

5. Verbindungsvorrichtung nach einem der Ansprüche 1 bis 4,
**dadurch gekennzeichnet, dass** der federnd ausgebildete Kontaktbereich (31) wenigstens eine Auswölbung oder Sicke (34) zur Bildung eines Kontaktpunkts (52) oder einer Kontaktierungsfläche mit dem herausgeführten Leiter (3) aufweist.

6. Verbindungsvorrichtung nach einem der vorhergehenden Ansprüche, **dadurch gekennzeichnet, dass** die Anschlusseinrichtung (30) an zumindest einem stromführenden Bauteil (20) anformbar ist, welches in dem Verbindergehäuse (10) anordenbar ist.

7. Verbindungsvorrichtung nach Anspruch 6,
**dadurch gekennzeichnet, dass** das stromführende Bauteil (20) als eine Stromschiene ausgebildet ist, bei der auf einer ersten Seite (21) zur Verbindung mit wenigstens einem elektrischen Leiter (61) ein Anschlussbereich (60) und auf einer zur ersten Seite gegenüberliegenden zweiten Seite (22) die Anschlusseinrichtung (30) vorgesehen sind.

8. Verbindungsvorrichtung nach Anspruch 7,
**dadurch gekennzeichnet, dass** die Stromschiene an der ersten Seite (21) im Anschlussbereich (60) mit einem Kontakt (61) verbunden ist, der auf einer der Stromschiene (20) abgewandten Seite einen Teil einer Steckverbindungsvorrichtung (70) bildet, an die ein externer Leiter (2) anschließbar ist.

9. Verbindungsvorrichtung nach Anspruch 7 oder 8,
**dadurch gekennzeichnet, dass** zwischen dem Anschlussbereich (60) und der Anschlusseinrichtung (30) wenigstens ein Befestigungsabschnitt (80) der Stromschiene (20) vorgesehen ist, welcher dazu vorgesehen ist, die Stromschiene (20) in dem Verbindergehäuse (10) zu fixieren.

10. Solaranlage mit wenigstens einem Solarmodul (100) und wenigstens einer Verbindungsvorrichtung (1) nach einem der vorhergehenden Ansprüche.

## Revendications

1. Dispositif de liaison (1) pour sa liaison à un système de connexion électrique d'un module solaire (100), comprenant :
- un boîtier de connecteur (10) qui doit venir se disposer sur une surface externe (103) du module solaire ;
- au moins un moyen de liaison (30) qui peut être prévu dans le boîtier de connecteur (10) et qui peut être relié à un conducteur (3), qui est guidé hors du module solaire, du système de connexion électrique du module solaire ;
- dans lequel le moyen de liaison (30) possède au moins une zone de contact conçue de manière résiliente (31), qui est conçue pour entrer en contact avec le conducteur guidé à l'extérieur (3) dans une position de mise en contact, et une zone de contact par accouplement (32) opposée à la zone de contact (31) conçue de manière résiliente, et la zone de contact (31) conçue de manière résiliente est conçue pour comprimer, dans la position de mise en contact, le conducteur guidé à l'extérieur (3) contre la zone de contact par accouplement (32), dans lequel la zone de contact (31) et la zone de contact par accouplement (32) sont reliées l'une à l'autre via une zone de liaison (33) ;
**caractérisé par le fait que**
- le moyen de liaison (30) possède au moins une portion d'engagement (41, 42) qui est conçue sous la forme d'un espace libre qui est configuré par la zone de contact (31) et la zone de contact par accouplement (32) et dans lequel un outil (44) peut être inséré dans le but de déplacer la zone de contact (31) conçue de manière résiliente pour lui faire quitter sa position de mise en contact.

2. Dispositif de liaison selon la revendication 1, **caractérisé en ce que** la portion d'engagement (41, 42) est conçue d'une manière telle que la zone de contact (31) peut être écartée de la zone de contact par accouplement (32) du moyen de liaison via l'insertion d'un outil.

3. Dispositif de liaison selon la revendication 1 ou 2, **caractérisé en ce que** la zone de liaison (33) représente une zone de liaison courbe (33), d'une manière telle que le moyen de liaison (30) est conçu sous la forme d'un contact élastique courbe.

4. Dispositif de liaison selon l'une quelconque des revendications 1 à 3, **caractérisé en ce que** la portion d'engagement (41, 42) est prévue en position adjacente à la zone de liaison (33).

5. Dispositif de liaison selon l'une quelconque des revendications 1 à 4, **caractérisé en ce que** la zone de contact (31) conçue de manière résiliente possède au moins un bombement ou une nervure (34) pour la formation d'un point de contact (52) ou d'une surface de mise en contact avec le conducteur guidé à l'extérieur (3).

6. Dispositif de liaison selon l'une quelconque des revendications précédentes, **caractérisé en ce que** le moyen de liaison (30) peut être moulé sur au moins un composant (20) transportant du courant qui peut être prévu dans le boîtier de connecteur (10).

7. Dispositif de liaison selon la revendication 6, **caractérisé en ce que** le composant (20) transportant du courant est conçu sous la forme d'une barre omnibus dans laquelle on prévoit une zone de liaison (60) sur un premier côté (21) à des fins de liaison à au moins un conducteur électrique (61) et le moyen de liaison (30) est prévu sur un second côté (22) qui est opposé au premier côté.

8. Dispositif de liaison selon la revendication 7, **caractérisé en ce que** la barre omnibus est reliée au premier côté (21) dans la zone de liaison (60) à un contact (61) qui forme, sur un côté éloigné de la barre omnibus (20), une partie d'un dispositif de liaison par enfichage (70) auquel un conducteur externe (2) peut venir se relier.

9. Dispositif de liaison selon la revendication 7 ou 8, **caractérisé en ce qu'**au moins une portion de fixation (80) de la barre omnibus (20), qui est prévue pour fixer la barre omnibus (20) dans le boîtier de connecteur (10), est prévue entre la zone de liaison (60) et le moyen de liaison (30).

10. Installation solaire comprenant au moins un module solaire (100) et au moins un dispositif de liaison (1) selon l'une quelconque des revendications précédentes.
